# EUROPEAN PATENT APPLICATION

(11) **EP 4 753 129 A1**
(43) Date of publication of application: **03.06.2026**
(21) Application number: 24906895.8
(22) Date of filing: 16.10.2024
(51) Int. Cl.: H02M 1/12, H01F 27/24, H01F 27/28, H02M 7/48

(54) **COMMON MODE FILTER CIRCUIT**

(30) Priority: 19.12.2023 JP 2023213703
(71) Applicant: IHI Corporation, Tokyo 135-8710 (JP)
(72) Inventor: HANEDA, Ryo, Tokyo 135-8710 (JP)
(74) Representative: TBK
(86) International application number: PCT/JP2024/036857
(87) International publication number: WO 2025/134507

(57) **Abstract**

A common mode filter circuit includes an annular core through which a secondary winding is inserted inside, a primary winding wound around the core so as to pass through an inside and an outside of the core, and a heat sink joined to an outer peripheral surface of the core. The core has a flat shape having a longitudinal direction and a transverse direction when viewed from a Z direction. The heat sink is joined to a core longitudinal portion existing along the longitudinal direction of the outer peripheral surface. The primary winding is wound around a core transverse portion existing along the transverse direction of the outer peripheral surface.

## Description

### Technical Field

The present disclosure relates to a common mode filter circuit.

### Background Art

Conventionally, a common mode filter circuit is known that includes an annular common mode transformer core through which a secondary winding is inserted inside, and a primary winding wound around the common mode transformer core so as to pass through an inside and an outside of the common mode transformer core (see Patent Literature 1 below).

### Citation List

### Patent Literature

Patent Literature 1: International Publication No. 2022-118847

### Summary of Invention

### Technical Problem

In this type of common mode filter circuit, the temperature of the common mode transformer core rises due to iron loss. If the common mode transformer core becomes too high in temperature, continuation of operation may become impossible. Therefore, the present disclosure describes a common mode filter circuit capable of appropriately cooling a common mode transformer core.

### Solution to Problem

A common mode filter circuit according to one aspect of the present disclosure is [1] "A common mode filter circuit comprising: an annular common mode transformer core through which a secondary winding is inserted inside; a primary winding wound around the common mode transformer core so as to pass through an inside and an outside of the common mode transformer core; and a cooler joined to an outer peripheral surface of the common mode transformer core, wherein the common mode transformer core has a flat shape having a longitudinal direction and a transverse direction when viewed from an insertion direction of the secondary winding, wherein the cooler is joined to a portion existing along the longitudinal direction of the outer peripheral surface, and the primary winding is wound around a portion existing along the transverse direction of the outer peripheral surface."

### Effects of Invention

The common mode filter circuit of the present disclosure allows the common mode transformer core to be appropriately cooled.

### Brief Description of Drawings

FIG. 1 is a diagram showing a common mode filter circuit of the present embodiment.
FIG. 2(a) is a diagram showing a physical structure of a passive common noise canceller, and FIG. 2(b) is a diagram showing a state of viewing it from a direction of an arrow IIb in FIG. 2(a).
FIG. 3 is a perspective view showing a common mode transformer included in the passive common noise canceller.
FIGS. 4(a) to (c) are diagrams respectively showing passive common noise cancellers according to modifications.
FIGS. 5(a) to (c) are diagrams respectively showing passive common noise cancellers according to other modifications.

### Description of Embodiments

The gist of the present disclosure lies in the following [1] to [6].
[1] A common mode filter circuit including: an annular common mode transformer core through which a secondary winding is inserted inside; a primary winding wound around the common mode transformer core so as to pass through an inside and an outside of the common mode transformer core; and a cooler joined to an outer peripheral surface of the common mode transformer core, wherein the common mode transformer core has a flat shape having a longitudinal direction and a transverse direction when viewed from an insertion direction of the secondary winding, wherein the cooler is joined to a portion existing along the longitudinal direction of the outer peripheral surface, and the primary winding is wound around a portion existing along the transverse direction of the outer peripheral surface.
[2] The common mode filter circuit according to [1], wherein a plurality of the secondary windings is provided, and the plurality of the secondary windings are arranged in the longitudinal direction.
[3] The common mode filter circuit according to [2], wherein the primary winding is wound around the common mode transformer core at a position aligned in the longitudinal direction with respect to the plurality of the secondary windings.
[4] The common mode filter circuit according to any one of [1] to [3], wherein a plurality of the common mode transformer cores arranged in an insertion direction of the secondary winding is provided, and the cooler is joined to outer peripheral surfaces of the plurality of the common mode transformer cores.
[5] The common mode filter circuit according to any one of [1] to [4], wherein a plurality of the common mode transformer cores and a plurality of the coolers are alternately arranged in the transverse direction in a state of being joined in order, and the secondary winding extends so as to pass through insides of the plurality of the common mode transformer cores.

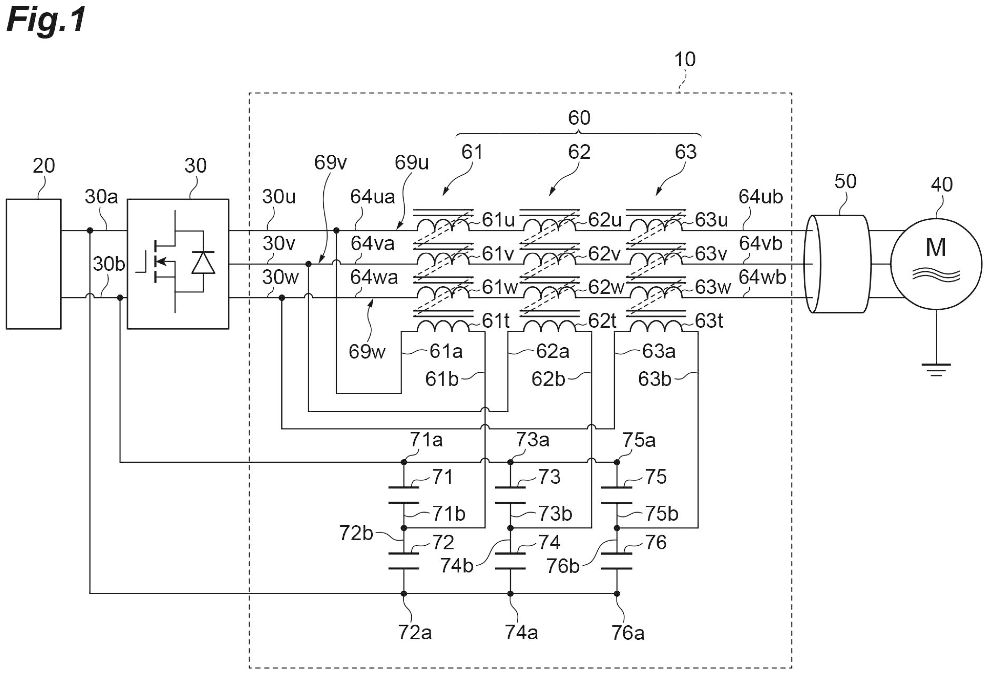

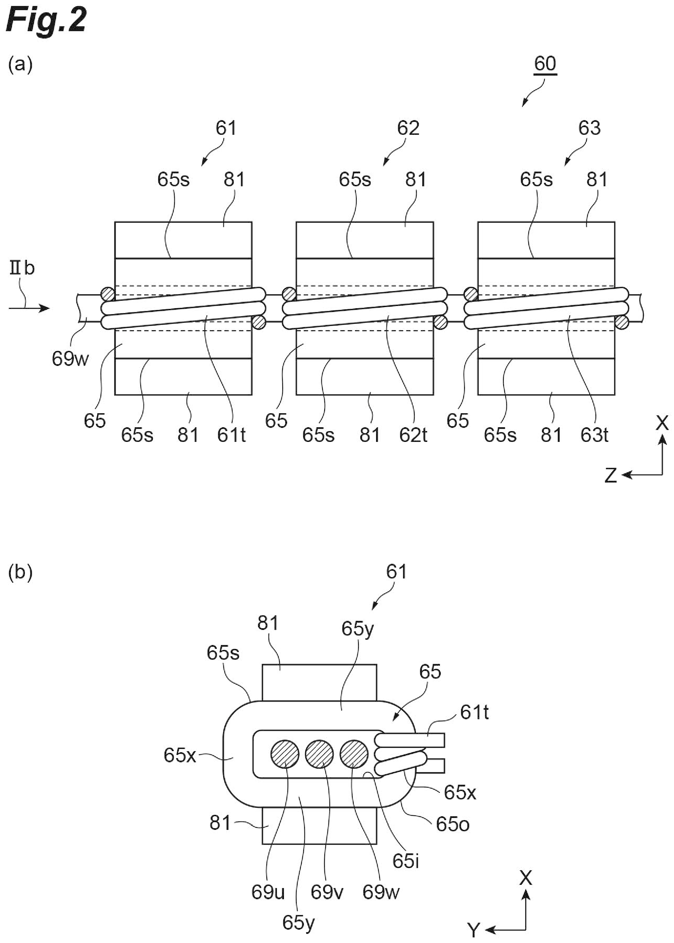

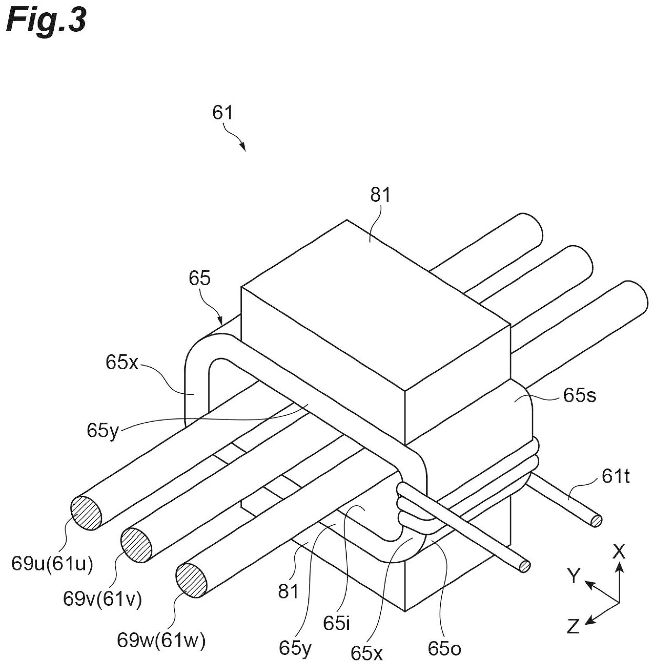

Hereinafter, embodiments will be described with reference to the drawings. FIG. 1 is a diagram showing a common mode filter circuit 10 of the present embodiment. FIG. 2(a) is a diagram showing a physical structure of a passive common noise canceller 60 included in the common mode filter circuit 10 of the present embodiment. FIG. 2(b) is a diagram showing a state of viewing the passive common noise canceller 60 from a direction of an arrow IIb in FIG. 2(a). FIG. 3 is a perspective view showing a common mode transformer 61 included in the passive common noise canceller 60.

As shown in FIG. 1, the common mode filter circuit 10 of the present embodiment is connected between an inverter 30 and a three-phase AC motor 40. The inverter 30 includes a pair of input terminals 30a, 30b connected to a power supply 20, and three output terminals 30u, 30v, 30w that output three-phase AC. Three-phase AC is supplied to the three-phase AC motor 40 from the output terminals 30u, 30v, 30w of the inverter 30 via a motor cable 50.

The power supply 20 is a DC power supply such as a battery and a converter. The inverter 30 is, for example, a voltage source PWM inverter. The inverter 30 converts a DC voltage supplied from the power supply 20 via the input terminals 30a, 30b into a three-phase AC voltage by a switching operation of a power semiconductor element (IGBT, SiC, etc.), and outputs the three-phase AC voltage from the output terminals 30u, 30v, 30w. The AC voltage converted by the inverter 30 is supplied to the three-phase AC motor 40 via the common mode filter circuit 10 and the motor cable 50. A frame of the three-phase AC motor 40 is connected to an installation voltage via a grounding wire.

The common mode filter circuit 10 includes the passive common noise canceller 60. The passive common noise canceller 60 includes three common mode transformers 61, 62, 63 that cancel a common mode voltage of the three-phase AC. Also, the common mode filter circuit 10 includes three pairs of capacitors 71, 72, 73, 74, 75, 76. The three pairs of capacitors 71, 72, 73, 74, 75, 76 are connected to the common mode transformers 61, 62, 63 and the input terminals 30a, 30b of the inverter 30, respectively.

The common mode transformer 61 includes a one-phase primary winding 61t and three-phase secondary windings 61u, 61v, 61w. The common mode transformer 62 includes a one-phase primary winding 62t and three-phase secondary windings 62u, 62v, 62w. The common mode transformer 63 includes a one-phase primary winding 63t and three-phase secondary windings 63u, 63v, 63w.

One ends 61a, 62a, 63a of the respective primary windings 61t, 62t, 63t of the three common mode transformers 61, 62, 63 are connected to the three output terminals 30u, 30v, 30w of the inverter 30, respectively. That is, the one end 61a of the primary winding 61t of the common mode transformer 61 is connected to the three-phase U-phase output terminal 30u of the inverter 30. The one end 62a of the primary winding 62t of the common mode transformer 62 is connected to the three-phase V-phase output terminal 30v of the inverter 30. The one end 63a of the primary winding 63t of the common mode transformer 63 is connected to the three-phase W-phase output terminal 30w of the inverter 30.

Other ends 61b, 62b, 63b of the respective primary windings 61t, 62t, 63t of the three common mode transformers 61, 62, 63 are connected to other ends 71b, 73b, 75b of the capacitors 71, 73, 75. The capacitor 71 is one of a pair of capacitors 71, 72 among the three pairs of capacitors 71, 72, 73, 74, 75, 76. The capacitor 73 is one of a pair of capacitors 73, 74 among the three pairs of capacitors 71, 72, 73, 74, 75, 76. The capacitor 75 is one of a pair of capacitors 75, 76 among the three pairs of capacitors 71, 72, 73, 74, 75, 76. One ends 71a, 73a, 75a of the capacitors 71, 73, 75 are connected to the input terminal 30b which is one of the pair of input terminals 30a, 30b of the inverter 30.

The other ends 61b, 62b, 63b of the respective primary windings 61t, 62t, 63t of the three common mode transformers 61, 62, 63 are connected to the other ends 72b, 74b, 76b of the capacitors 72, 74, 76. The capacitor 72 is the other of the pair of capacitors 71, 72 among the three pairs of capacitors 71, 72, 73, 74, 75, 76. The capacitor 74 is the other of the pair of capacitors 73, 74 among the three pairs of capacitors 71, 72, 73, 74, 75, 76. The capacitor 76 is the other of the pair of capacitors 75, 76 among the three pairs of capacitors 71, 72, 73, 74, 75, 76. One ends 72a, 74a, 76a of the capacitors 72, 74, 76 are connected to the input terminal 30a which is the other of the pair of input terminals 30a, 30b of the inverter 30.

That is, the other end 61b of the primary winding 61t of the common mode transformer 61 connected to the U-phase of the inverter 30 is connected to the other end 71b of the capacitor 71 and the other end 72b of the capacitor 72. The one end 71a of the capacitor 71 is connected to the one input terminal 30b of the inverter 30. The one end 72a of the capacitor 72 is connected to the other input terminal 30a of the inverter 30.

The other end 62b of the primary winding 62t of the common mode transformer 62 connected to the V-phase of the inverter 30 is connected to the other end 73b of the capacitor 73 and the other end 74b of the capacitor 74. The one end 73a of the capacitor 73 is connected to the one input terminal 30b of the inverter 30. The one end 74a of the capacitor 74 is connected to the other input terminal 30a of the inverter 30.

The other end 63b of the primary winding 63t of the common mode transformer 63 connected to the W-phase of the inverter 30 is connected to the other end 75b of the capacitor 75 and the other end 76b of the capacitor 76. The one end 75a of the capacitor 75 is connected to the one input terminal 30b of the inverter 30. The one end 76a of the capacitor 76 is connected to the other input terminal 30a of the inverter 30. The primary windings 61t, 62t, 63t and the capacitors 71, 72, 73, 74, 75, 76 constitute a filter that detects common mode voltages of the U-phase, V-phase, and W-phase.

The three-phase secondary windings 61u, 61v, 61w, 62u, 62v, 62w, 63u, 63v, 63w of the three common mode transformers 61, 62, 63 are respectively connected in series with each other. One ends 64ua, 64va, 64wa of the respective three-phase secondary windings 61u, 61v, 61w, 62u, 62v, 62w, 63u, 63v, 63w of the three common mode transformers 61, 62, 63 connected in series with each other are connected to the three output terminals 30u, 30v, 30w of the inverter 30, respectively.

The other ends 64ub, 64vb, 64wb of the respective three-phase secondary windings 61u, 61v, 61w, 62u, 62v, 62w, 63u, 63v, 63w of the three common mode transformers 61, 62, 63 connected in series with each other are connected to respective phases of the three-phase AC motor 40 via the motor cable 50.

That is, the U-phase secondary windings 61u, 62u, 63u of the common mode transformers 61, 62, 63 are connected in series with each other. The one end 64ua of the secondary windings 61u, 62u, 63u is connected to the U-phase output terminal 30u of the inverter 30. The other end 64ub of the secondary windings 61u, 62u, 63u is connected to the U-phase of the three-phase AC motor 40.

The V-phase secondary windings 61v, 62v, 63v of the common mode transformers 61, 62, 63 are connected in series with each other. The one end 64va of the secondary windings 61v, 62v, 63v is connected to the V-phase output terminal 30v of the inverter 30. The other end 64vb of the secondary windings 61v, 62v, 63v is connected to the V-phase of the three-phase AC motor 40.

The W-phase secondary windings 61w, 62w, 63w of the common mode transformers 61, 62, 63 are connected in series with each other. The one end 64wa of the secondary windings 61w, 62w, 63w is connected to the W-phase output terminal 30w of the inverter 30. The other end 64wb of the secondary windings 61w, 62w, 63w is connected to the W-phase of the three-phase AC motor 40.

A ratio of the number of turns of the respective primary windings 61t, 62t, 63t of the three common mode transformers 61, 62, 63 to the number of turns of the secondary windings 61u, 61v, 61w, 62u, 62v, 62w, 63u, 63v, 63w is 3:1. In the present embodiment, the number of turns of the respective primary windings 61t, 62t, 63t of the three common mode transformers 61, 62, 63 is 3, and the number of turns of the respective secondary windings 61u, 61v, 61w, 62u, 62v, 62w, 63u, 63v, 63w of the three common mode transformers 61, 62, 63 is 1 (only passing through the inside of a core 65 described later).

Hereinafter, the passive common noise canceller 60 will be further described with reference to FIGS. 2 and 3. As described above, the passive common noise canceller 60 includes the three common mode transformers 61, 62, 63. These three common mode transformers 61, 62, 63 have configurations similar to each other. Therefore, the common mode transformer 61 is shown as a representative in FIG. 3, and the configuration of the common mode transformer 61 will be described below as a representative, and overlapping descriptions of the common mode transformers 62, 63 may be omitted.

As shown in FIGS. 2 and 3, the common mode transformer 61 has an annular common mode transformer core 65 (hereinafter simply referred to as "core 65") made of a magnetic material. The core 65 is, for example, an iron core. The primary winding 61t of the common mode transformer 61 is wound three times by passing through an inside 65i and an outside 65o of the annular core 65.

The secondary windings 61u, 61v, 61w of the common mode transformer 61 are each wound once by passing through the inside 65i of the core 65 of the common mode transformer 61 only once. Thus, a common mode transformer having a structure in which the secondary winding passes through the inside of the core only once may be generally referred to as a "through-type common mode transformer" or the like.

The primary winding 61t is an electric wire, which is a conductive wire made of a metal with high electrical conductivity such as copper or aluminum covered with an insulating coating. The secondary windings 61u, 61v, 61w are electric wires or busbars, and are made of a material with high electrical conductivity such as copper or aluminum.

Further, the common mode transformer 61 includes two heat sinks 81, 81 joined to the core 65. The heat sinks 81, 81 function as coolers for cooling the core 65. Details of the heat sinks 81, 81 will be described later.

In this common mode filter circuit 10 (FIG. 1), a U-phase secondary winding 69u, a V-phase secondary winding 69v, and a W-phase secondary winding 69w pass through the insides 65i of the three cores 65 of the common mode transformers 61, 62, 63 in order, respectively. The three cores 65 of the common mode transformers 61, 62, 63 are arranged in a straight line, and the secondary windings 69u, 69v, 69w extend linearly penetrating the three cores 65.

Of the secondary winding 69u, a portion passing through the common mode transformer 61 is the secondary winding 61u (FIG. 1), a portion passing through the common mode transformer 62 is the secondary winding 62u (FIG. 1), and a portion passing through the common mode transformer 63 is the secondary winding 63u (FIG. 1).

Similarly, of the secondary winding 69v, a portion passing through the common mode transformer 61 is the secondary winding 61v (FIG. 1), a portion passing through the common mode transformer 62 is the secondary winding 62v (FIG. 1), and a portion passing through the common mode transformer 63 is the secondary winding 63v (FIG. 1).

Similarly, of the secondary winding 69w, a portion passing through the common mode transformer 61 is the secondary winding 61w (FIG. 1), a portion passing through the common mode transformer 62 is the secondary winding 62w (FIG. 1), and a portion passing through the common mode transformer 63 is the secondary winding 63w (FIG. 1).

According to the common mode filter circuit 10 as described above, the common mode voltage that can cause bearing failure of the three-phase AC motor 40 is reduced.

Here, in the common mode transformers 61, 62, 63 as described above, the temperature of the core 65 rises due to iron loss. If the core 65 becomes too high in temperature, continuation of operation may become impossible. Therefore, the common mode transformers 61, 62, 63 have a configuration for appropriately cooling the core 65. Next, a specific configuration for appropriately cooling the core 65 in the passive common noise canceller 60 will be described.

The secondary windings 69u, 69v, 69w in the present embodiment extend linearly within a range where the passive common noise canceller 60 is constructed. Further, as shown in FIGS. 2 and 3, the core 65 has a flat shape having a longitudinal direction and a transverse direction when viewed from an insertion direction of the secondary windings 69u, 69v, 69w. Specifically, the core 65 in the present embodiment has a cylindrical shape extending in the insertion direction of the secondary windings 69u, 69v, 69w, and forms a rectangle with rounded corners (rounded rectangle) when viewed from the insertion direction of the secondary windings 69u, 69v, 69w. The secondary windings 69u, 69v, 69w are arranged in the longitudinal direction of the rounded rectangle, extend parallel to each other, and pass through the inside 65i of the core 65. Hereinafter, X, Y, and Z may be used to describe the positional relationship of each part, with the longitudinal direction of the rounded rectangle being the Y direction, the transverse direction being the X direction, and the insertion direction of the secondary windings 69u, 69v, 69w being the Z direction.

In the core 65 forming a rounded rectangle when viewed from the Z direction, there are two portions extending linearly in the Y direction, two portions extending linearly in the X direction, and four rounded corner portions existing between these portions. Hereinafter, a portion of the core 65 extending linearly in the Y direction when viewed from the Z direction is referred to as a "core longitudinal portion" and denoted by reference sign "65y". The core longitudinal portion 65y is a flat plate-like portion having a thickness in the X direction and parallel to the YZ plane. Also, a portion of the core 65 extending linearly in the X direction when viewed from the Z direction is referred to as a "core transverse portion" and denoted by reference sign "65x". The core transverse portion 65x is a flat plate-like portion having a thickness in the Y direction and parallel to the XZ plane.

The common mode transformer 61 includes two heat sinks 81, 81 joined to the core 65 in order to cool the core 65. The two heat sinks 81, 81 are arranged so as to sandwich the core 65 therebetween in the X direction and are provided so as to project from the core 65 in the X direction. The heat sinks 81 and the core 65 are joined such that a surface of the heat sinks 81 and an outer peripheral surface 65s of the core 65 are in close contact. The heat sinks 81 are made of a material with high thermal conductivity such as copper or aluminum, and exchange heat with the joined core 65. A joining method of the heat sinks 81 and the core 65 may be, for example, adhesion using an adhesive. Further, a heat conduction portion (not shown) made of a thermally conductive material (TIM: Thermal Interface Material) may be interposed between the heat sinks 81 and the core 65. Note that the heat sinks 81, 81 are electrically insulated from the primary winding 61t and the secondary windings 69u, 69v, 69w.

The heat sinks 81 in the present embodiment form a rectangular parallelepiped and are joined to the outer peripheral surface 65s in the core longitudinal portion 65y. Dimensions of the heat sinks 81 in the Y direction and the Z direction are substantially equal to dimensions of the core longitudinal portions 65y in the Y direction and the Z direction, and the heat sinks 81 are provided over substantially the entirety of the core longitudinal portions 65y.

Note that the dimensions of the heat sinks 81 in the Y direction and the Z direction may be larger or smaller than the dimensions of the core longitudinal portions 65y in the Y direction and the Z direction. When the dimension of the heat sinks 81 in the Y direction is larger than that of the core longitudinal portions 65y, both ends of the heat sinks 81 in the Y direction may protrude from the core longitudinal portions 65y in the Y direction. In this case, there may be a gap in the X direction between the protruding portion and the rounded corner portion of the core 65.

The heat sinks 81 as described above are respectively joined to the two core longitudinal portions 65y of the core 65 of the common mode transformer 61. That is, the common mode transformer 61 includes the core 65 and the two heat sinks 81, 81 arranged with the core 65 sandwiched therebetween.

The primary winding 61t of the common mode transformer 61 is wound around the core transverse portion 65x. That is, the primary winding 61t is wound three times around the core transverse portion 65x so as to alternately pass through the inside 65i and the outside 65o of the core 65. Therefore, the primary winding 61t does not interfere with the heat sinks 81 arranged on the core longitudinal portion 65y. The primary winding 61t is wound around the core transverse portion 65x at a position aligned in the Y direction with respect to the three secondary windings 69u, 69v, 69w. Thus, the common mode transformer 61 can be made compact by an arrangement in which the secondary windings 69u, 69v, 69w are arranged in the Y direction and pass through the inside 65i of the core 65, and a winding portion of the primary winding 61t is located at a position aligned in the Y direction with respect to these secondary windings 69u, 69v, 69w.

The passive common noise canceller 60 includes the three common mode transformers 61, 62, 63 having the above configuration, and the three common mode transformers 61, 62, 63 are arranged in the Z direction.

Note that FIGS. 2 and 3 schematically represent parts necessary for explaining the structure of the common mode transformer 61 of the present embodiment in an exaggerated manner, and do not show the exact shape or dimensions of each part. For example, although the heat sinks 81 are schematically illustrated as a relatively simple rectangular parallelepiped in FIGS. 2 and 3, the actual heat sinks 81 may have a large number of thin plate-like parallel fins. A heat sink having such a large number of fins may be generally referred to as a "comb-shaped heat sink". Further, for example, the heat sinks 81 may be a hollow member having a hollow portion through which a refrigerant (for example, cooling air or cooling water) passes.

Subsequently, functions and effects of the common mode filter circuit 10 of the present embodiment as described above will be described. In the common mode transformers 61, 62, 63, the heat sinks 81, 81 joined to the core 65 exchange heat with the core 65. That is, the heat of the core 65 that has become high temperature is transferred to the heat sinks 81, 81. Then, the core 65 is cooled by dissipating the heat transferred from the core 65 to the outside from the heat sinks 81, 81. A method of heat dissipation from the heat sinks 81, 81 to the outside, that is, a method of cooling the heat sinks 81, 81, may be a natural air cooling, a forced air cooling, or a water cooling. That is, a cooling unit that cools the heat sinks 81, 81 by any of the methods as described above may be appropriately provided in an apparatus in which the common mode filter circuit 10 is constructed. Then, specifications of the heat sinks 81 may be designed according to specifications of the cooling unit. That is, for example, when the cooling unit is a blower and the heat sinks 81 are comb-shaped, the heat sinks 81 may be designed such that the direction of the fins of the heat sinks 81 is parallel to a flow direction of cooling air by the cooling unit.

Thus, according to the common mode filter circuit 10, the core 65 can be appropriately cooled. Then, by appropriately designing the cooling capacity of the heat sinks 81, 81, it is possible to prevent the temperature of the core 65 from reaching an allowable upper limit.

The present disclosure can be implemented in various forms with various changes and improvements based on the knowledge of those skilled in the art, including the above-described embodiments. Further, for example, the following modifications can be configured using the technical matters described in the above-described embodiments. Configurations of the respective embodiments and the like may be used in appropriate combination.

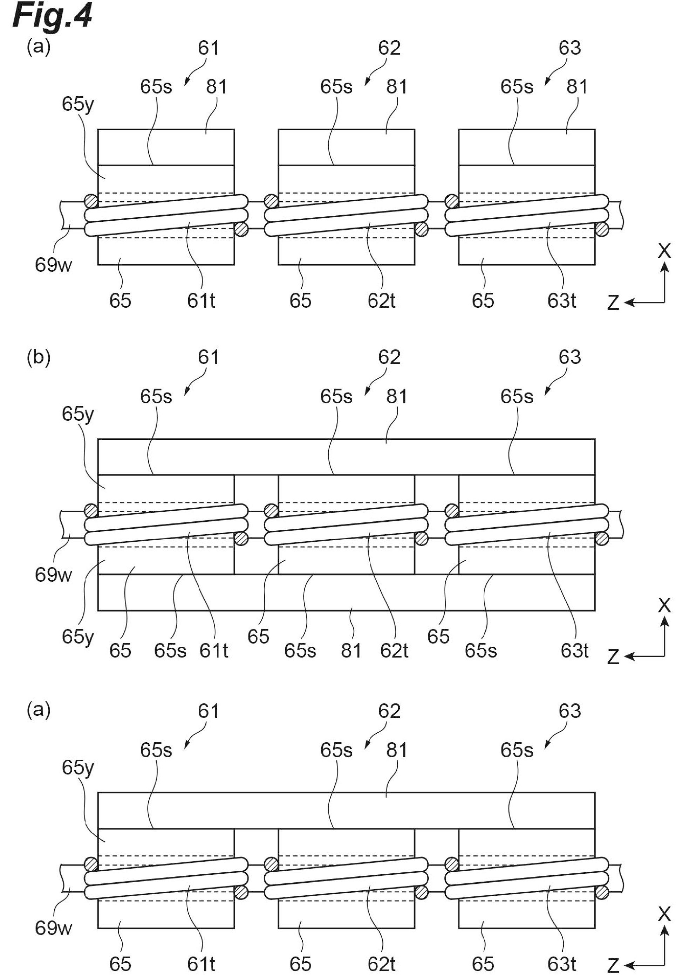

For example, it is not essential that the heat sinks 81, 81 are joined to both sides of the core 65, and for example, as shown in FIG. 4(a), the heat sink 81 may be joined only to one core longitudinal portion 65y of each core 65 in each common mode transformer 61, 62, 63.

Further, as shown in FIG. 4(b), the heat sinks 81, 81 joined to the three cores 65 of the respective common mode transformers 61, 62, 63 may be respectively integrally shared. In this case, one heat sink 81 is extended to a length of three or more times the dimension of the core 65 in the Z direction, and is joined to the core longitudinal portions 65y of the three cores 65. The number of parts can be reduced by such sharing of the heat sink 81. Also in this case, as shown in FIG. 4(c), the heat sink 81 may be provided only on one core longitudinal portion 65y of each core 65.

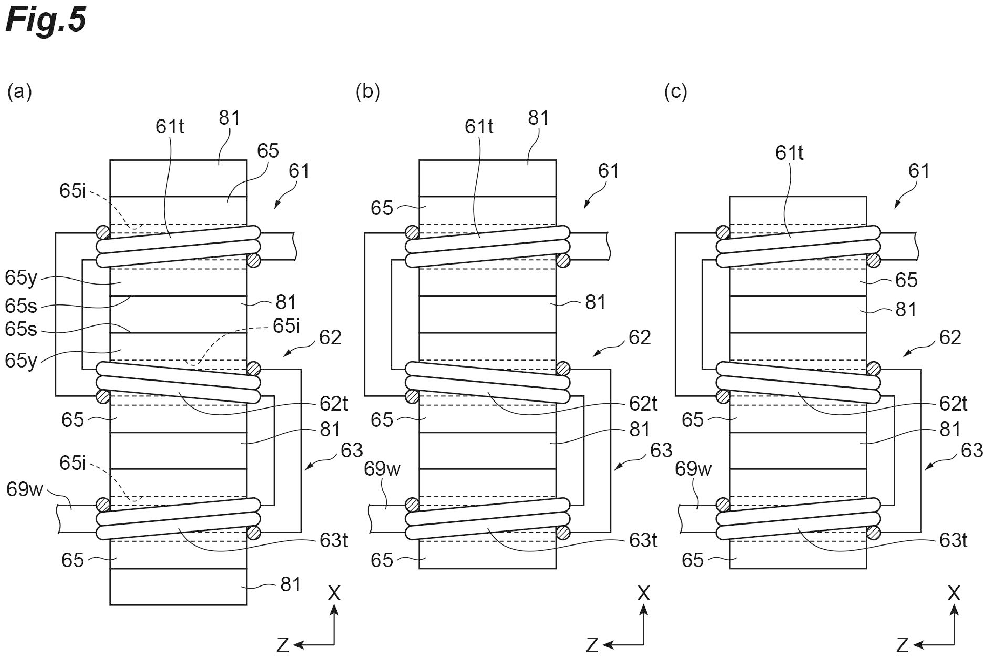

Further, as shown in FIG. 5(a), the three common mode transformers 61, 62, 63 may be arranged in the X direction. In this case, in order to pass through the insides 65i of the three respective cores 65 in order, the secondary windings 69u, 69v, 69w are laid in an S-shaped path. In this case, in the core 65 of the common mode transformers 61, 63 and the core 65 of the common mode transformer 62, passing directions of the secondary windings 69u, 69v, 69w are opposite. Correspondingly, in the primary windings 61t, 63t of the common mode transformers 61, 63 and the primary winding 62t of the common mode transformer 62, winding directions with respect to the core 65 are opposite. Note that passing directions of the three secondary windings 69u, 69v, 69w with respect to one core 65 are all the same. In the form of FIG. 5(a), the heat sink 81 between the cores 65 adjacent to each other in the X direction is integrally shared. Both opposing surfaces of one shared heat sink 81 are respectively joined to the outer peripheral surfaces 65s of the core longitudinal portions 65y of the two cores 65. Then, the three cores 65 and the four heat sinks 81 are alternately arranged in the X direction in a state of being joined in order. The number of parts can be reduced by such sharing of the heat sinks 81.

Further, in the configuration in which the cores 65 and the heat sinks 81 are alternately arranged as described above, the heat sink 81 at one end of the arrangement may be omitted, and for example, a configuration as shown in FIG. 5(b) may be adopted. In this case, the three cores 65 and the three heat sinks 81 are alternately arranged. Also, the heat sinks 81 at both ends of the arrangement may be omitted, and for example, a configuration as shown in FIG. 5(c) may be adopted. In this case, the three cores 65 and the two heat sinks 81 are alternately arranged.

Further, the shape of the core 65 is not limited to one having a cross section of a rounded rectangle as long as it is an annular shape allowing inserting of the secondary windings 69u, 69v, 69w and having a flat cross section. For example, the shape of the core 65 or the heat sink 81 may be an annular shape forming an ellipse when viewed from the Z direction, an annular shape forming a rectangle, or an oval shape. Also in this case, the heat sink 81 may be joined to a portion existing along the longitudinal direction of the outer peripheral surface 65s of the core 65. Further, the primary winding 61t may be wound around a portion extending along the transverse direction of the outer peripheral surface 65s so as not to interfere with the heat sinks 81. When the outer peripheral surface 65s is not a flat surface but a curved surface in the portion extending along the longitudinal direction of the core 65, a joining surface of the heat sink 81 may be formed according to the curved shape of the curved surface.

The secondary windings 69u, 69v, 69w may be electric wires or busbars as described above. There is no restriction on how to arrange the three secondary windings 69u, 69v, 69w, as long as they are inserted inside the core 65. Further, the secondary windings 69u, 69v, 69w may extend linearly or may be bent.

The core 65 and the heat sinks 81 are not limited to integrally formed members, and may be composed of a plurality of parts divided in a circumferential direction.

### Reference Signs List

10: Common mode filter circuit
60: Passive common noise canceller
61, 62, 63: Common mode transformer
61t, 62t, 63t: Primary winding
69u, 69v, 69w: Secondary winding
65: Core (Common mode transformer core)
65y: Core longitudinal portion
65x: Core transverse portion
65s: Outer peripheral surface
65i: Inside
65o: Outside
81: Heat sink (Cooler)

## Claims

1. A common mode filter circuit comprising:
an annular common mode transformer core through which a secondary winding is inserted inside;
a primary winding wound around the common mode transformer core so as to pass through an inside and an outside of the common mode transformer core; and
a cooler joined to an outer peripheral surface of the common mode transformer core,
wherein the common mode transformer core has a flat shape having a longitudinal direction and a transverse direction when viewed from an insertion direction of the secondary winding,
wherein the cooler is joined to a portion existing along the longitudinal direction of the outer peripheral surface, and
wherein the primary winding is wound around a portion existing along the transverse direction of the outer peripheral surface.

2. The common mode filter circuit according to Claim 1, wherein a plurality of the secondary windings is provided, and the plurality of the secondary windings are arranged in the longitudinal direction.

3. The common mode filter circuit according to Claim 2, wherein the primary winding is wound around the common mode transformer core at a position aligned in the longitudinal direction with respect to the plurality of the secondary windings.

4. The common mode filter circuit according to Claim 1,
wherein a plurality of the common mode transformer cores arranged in an insertion direction of the secondary winding is provided, and
wherein one said cooler is joined to outer peripheral surfaces of the plurality of the common mode transformer cores.

5. The common mode filter circuit according to Claim 1, comprising:
a plurality of the common mode transformer cores arranged in the transverse direction; and
the cooler arranged between the plurality of the common mode transformer cores and joined to each of the plurality of the common mode transformer cores,
wherein the secondary winding extends so as to pass through insides of the plurality of the common mode transformer cores.
